# EUROPEAN PATENT APPLICATION

(11) **EP 1 396 888 A2**
(43) Date of publication of application: **10.03.2004**
(21) Application number: 03019648.9
(22) Date of filing: 05.09.2003
(51) Int. Cl.: H01L 27/146

(54) **Solid-state imaging device**

(30) Priority: 05.09.2002 JP 2002259602
(71) Applicant: Kabushiki Kaisha Toshiba, Tokyo (JP)
(72) Inventor: Ayabe, Masayuki, Toshiba Corp., Minato-ku, Tokyo (JP); Yamashita, Hirofumi, Toshiba Corp., Minato-ku, Tokyo (JP); Inoue, Ikuko, Toshiba Corp., Minato-ku, Tokyo (JP); Egi, Yuichiro, Toshiba Corp., Minato-ku, Tokyo (JP)
(74) Representative: HOFFMANN - EITLE

(57) **Abstract**

A solid-state imaging device comprises: unit cells in matrix where rows and columns of them are arranged in an upper surface of a semiconductor substrate, each of the unit cells including a photodiode that develops a certain level of signal charge in response to an amount of incident light and accumulates the signal charge, and a readout circuit for reading the signal charge from the photodiode, interlayer films laid over the semiconductor substrate and having wiring layers provided therein, light shield film formed over the interlayer films and having an aperture provided right above the photodiode in each of the unit cells, trains of first light shield upright barrier walls located in a space between two adjacent unit cells arranged in the same column, and trains of second light shield upright barrier walls located in a space between the adjacent unit cells in the same row, the first and second light shield upright barrier walls being embedded in the interlayer films between the semiconductor substrate and the light shield film.

## Description

### BACKGROUND OF THE INVENTION

The present invention relates to a solid-state imaging device, and more particularly, to such an apparatus capable of reducing cross-talk caused by stray light.

For this decade, a solid state imaging device, especially, a metal oxide semiconductor (MOS) solid state imaging device (commonly known as a complementary metal oxide semiconductor (CMOS) image sensor) has been attracting notice and become popular in various applications because of its advantageous features of low voltage, single power supply, and reduced manufacturing cost.

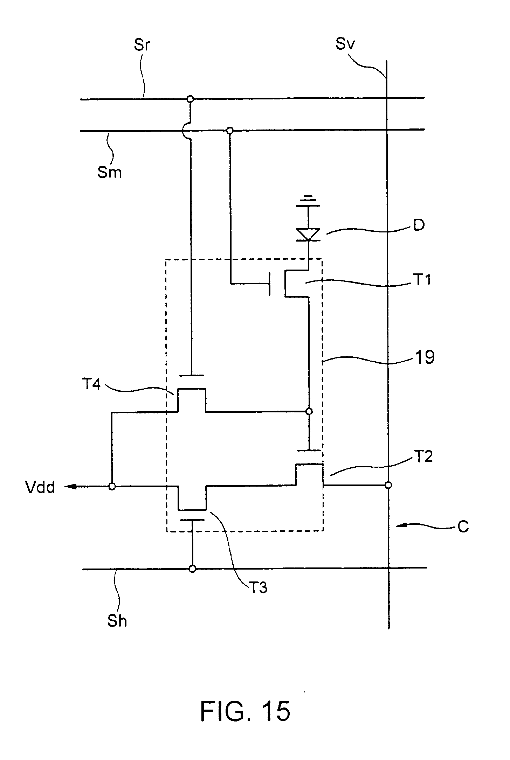

Such a MOS type solid-state imaging device, in general, has a circuit configuration as depicted in Fig. 15. Referring to Fig. 15, a unit cell C of the MOS solid-state imaging device is comprised of a photodiode D that produces signal charge in response to received light to accumulate it, a transistor T1 reading a signal from the charge, a transistor T2 amplifying the signal, a transistor T3 selecting a row from which the signal is to be taken, and a transistor T4 clearing the signal charge for reset, and the MOS solid-state imaging device usually has a plurality of the unit cells C in matrix where rows and columns of them are lined in two-dimensional arrangement.

The readout transistor T1 has its gate connected to a node of a readout signal line Sm, the amplification transistor T2 has its source connected to a node of a signal line Sv longitudinally extending in the drawing, the selector transistor T3 has its gate connected to a node of an address signal line Sh transversely extending in the drawing, and the reset transistor T4 has its gate connected to a node of a reset signal line Sr. A circuitry 19 consists of the transistors T1, T2, T3 and T4.

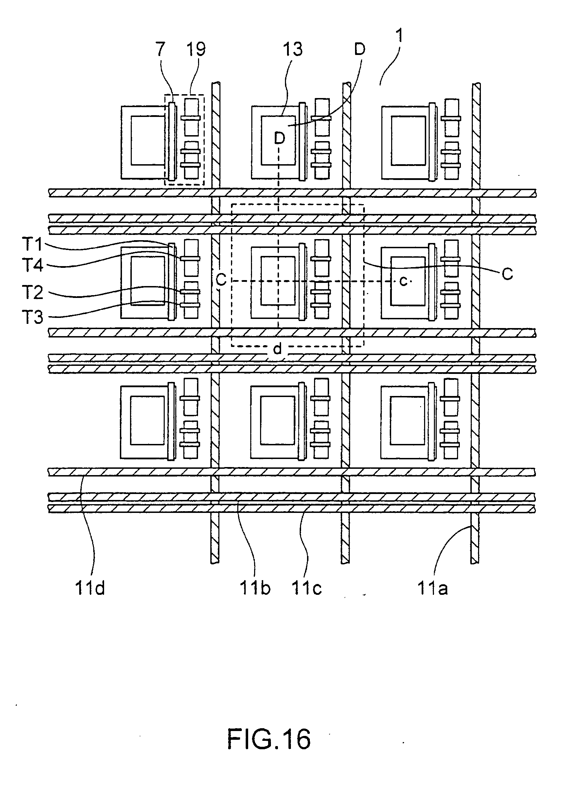

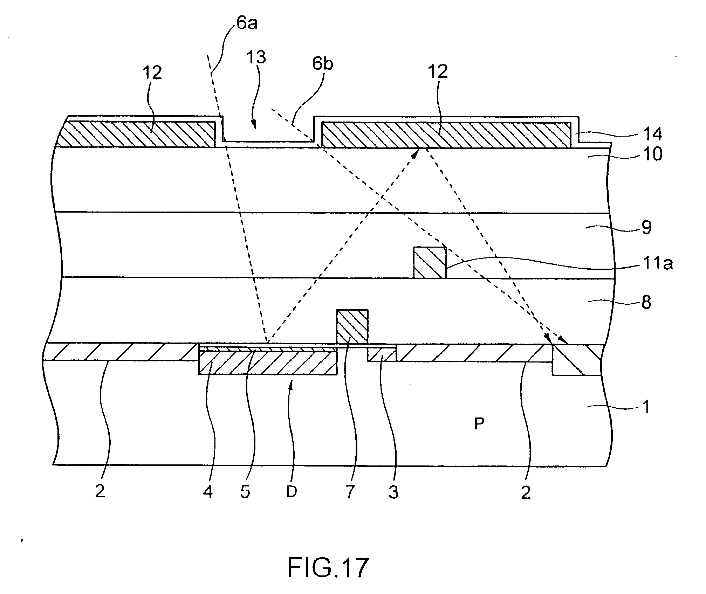

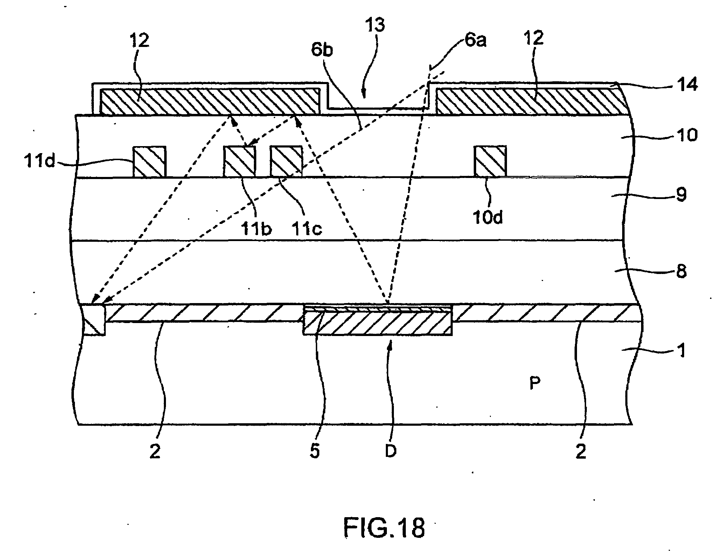

Such a MOS solid-state imaging device is generally configured as illustrated in Figs. 15 to 17 in the prior art. Fig. 16 is a schematic plan view showing the prior art MOS solid-state imaging device. Fig. 17 is a partial schematic cross-sectional view showing the unit cell C taken along the line C-c of Fig. 16. Fig. 18 is a partial schematic cross-sectional view showing the unit cell C taken along the line D-d of Fig. 16.

As can be seen in Fig. 16, a semiconductor substrate 1 is overlaid with a plurality of the unit cells C in matrix where rows and columns of them are lined in two-dimensional array, and the cells are respectively surrounded by cell formation areas that are defined by device isolation regions.

Metal wiring layers 11b, 11c and 11d extend transversely in Fig. 16 through the cell formation areas in the vicinities of the rows of the unit cells, and the layers 11b and 11c serving as the rest signal line Sr and the readout signal line Sm are on one side of each unit cell while the layer 11d serving as the address signal line Sh is on the opposite side of the unit cell.

Additional metal wiring layers 11a extend longitudinally in Fig. 16 through the cell formation areas in the vicinities of the columns of the unit cells, serving as the signal line Sv.

As to the single unit cells C, as will be recognized in Figs. 16 and 17, for example, the cell formation area, which is defined by the device isolation region 2 in the surface part of the P type semiconductor substrate 1, is provided with an N type drain layer 3 and an N type charge accumulating layer 4, and the latter is to serve as the photodiode D. The N type charge accumulating layer 4 is overlaid with a P⁺ type surface shield layer 5. In this way, P⁺NP type embedded photodiode D is created to accumulate a certain level of signal charge, depending upon an amount of incident light 6a. Also, a gate 7 is formed on an overlying gate oxide film, in position between the N type charge accumulating layer 4 and the N type drain layer 3, and thus, the readout transistor T1 is configured in this manner.

In the vicinity of the readout transistor T1, there are formed over the surface of the P type semiconductor substrate 1 an N type source layer, an N type drain-source shared layer, and an N type drain layer (all of them are not shown), gates are formed on the overlying gate oxide film, in positions between the N type source layer and the N type drain-source shared layer and between the N type drain-source shared layer and the N type drain layer, respectively. In this manner, the amplification transistor T2 and the selector transistor T3 are configured. In addition to that, adjacent to the readout transistor T1 in the surface part of the P type semiconductor substrate 1, an N type source layer and an N type drain layer are formed (both of them are not shown), and a gate is formed on the overlying gate oxide film, in position between the N type source layer and the N type drain layer, thereby configuring the reset transistor T4 in such a manner.

Then, first, second, and third interlayer films 8, 9 and 10 are successively formed in this order over the entire surface of the P type semiconductor substrate 1, and thereafter, the metal wiring layer 11a is deposited over the first interlayer film 8 to serve as the signal line Sv while the metal wiring layers 11b, 11c and 11d are selectively deposited over the second interlayer film 9 to serve as the reset signal line Sr, the readout signal line Sm, and the address signal line Sh, respectively. Over the third interlayer film 10, a light shield film 12 is formed, extending transversely in the drawings. The light shield film 12 has an aperture 13 defined to direct incident light at the photodiode D. The third interlayer film 10 along with the light shield film 12 is overlaid with a surface protection layer 14 of silicon nitride film or the like.

In the prior MOS solid-state imaging device as stated above, the light shield film 12 and the metal wiring layers 11a, 11b, 11c and 11d are made of material of high reflectance such as aluminum, copper, or the like, and hence, as shown in Figs. 16 and 17, part of the incident light upon one of the photodiodes D is, after reflected from the surface of the semiconductor substrate 1, irregularly reflected from the metal wiring layers 11a, 11b, 11c and 11d and undesirably directed to adjacent ones of the photodiodes D.

The incident light 6b, when propagated at reduced angle, is prone to directly trespass the adjacent photodiodes D. This may cause cross-talk which leads to a problem of degradation of chromatic reproducibility such as color mixing.

### SUMMARY OF THE INVENTION

According to an embodiment of the present invention, there is provided a solid-state imaging device comprising
unit cells in matrix where rows and columns of them are arranged in an upper surface of a semiconductor substrate, each of the unit cells including a photodiode that develops a certain level of signal charge in response to an amount of incident light and accumulates the signal charge, and a readout circuit for reading the signal charge from the photodiode,
interlayer films laid over the semiconductor substrate and having wiring layers provided therein,
light shield film formed over the interlayer films and having an aperture provided right above the photodiode in each of the unit cells,
trains of first light shield upright barrier walls located in a space between two adjacent unit cells arranged in the same column, and
trains of second light shield upright barrier walls located in a space between the adjacent unit cells in the same row,
the first and second light shield upright barrier walls being embedded in the interlayer films between the semiconductor substrate and the light shield film.

### BRIEF DESCRIPTION OF THE DRAWINGS

Fig. 1 is a schematic plan view showing a first embodiment of a MOS solid-state imaging device according to the present invention;
Fig. 2 is a schematic cross-sectional view showing one of unit cells C taken along the line A-a of Fig. 1;
Fig. 3 is a schematic cross-sectional view showing the unit cell C taken along the line B-b of Fig. 1;
Figs. 4A to 4I are partial vertical sectional views illustrating steps of manufacturing the unit cells C in the first embodiment of the MOS solid-state imaging device according to the present invention;
Figs. 5A to 5C are partial vertical sectional views illustrating steps of manufacturing unit cells C in another embodiment of the MOS solid-state imaging device according to the present invention;
Figs. 6A to 6H are partial vertical sectional views illustrating an additional process of manufacturing unit cells C in still another embodiment of the MOS solid-state imaging device according to the present invention;
Figs. 7A to 7C are partial vertical sectional views illustrating a process of manufacturing unit cells C in further another embodiment of the MOS solid-state imaging device according to the present invention;
Fig. 8 is a schematic plan view showing a second embodiment of the MOS solid-state imaging device according to the present invention;
Figs. 9, 10 , 11, 12, 13 and 14 are vertical cross sectional views showing variations from the first and second embodiments of the MOS solid-state imaging device, respectively;
Fig. 15 is a circuit diagram showing a unit cell C in a prior art MOS solid-state imaging device;
Fig. 16 is a schematic cross-sectional view showing the prior art MOS solid-state imaging device;
Fig. 17 is a schematic vertical sectional view showing the unit cell C taken along the line C-c of Fig. 16; and
Fig. 18 is a schematic vertical sectional view showing the unit cell C taken along the line D-d of Fig. 16.

### DETAILED DESCRIPTION

Embodiments of the present invention will now be described in conjunction with the accompanying drawings.

### <Embodiment 1>

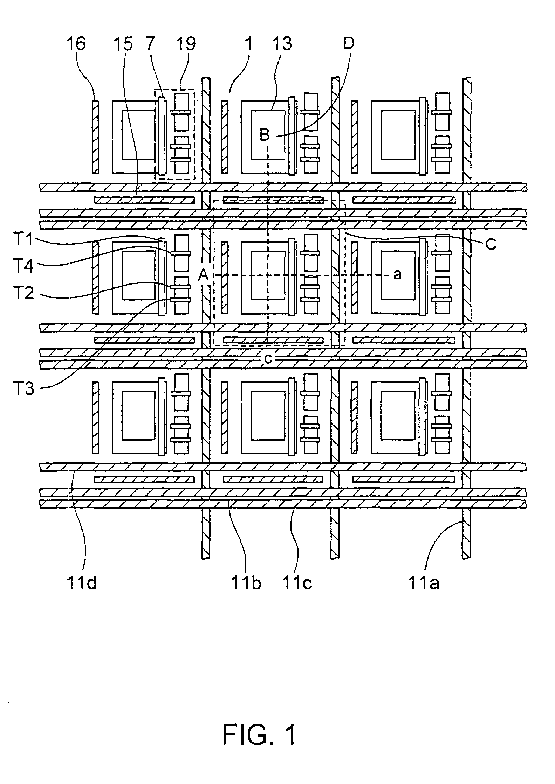

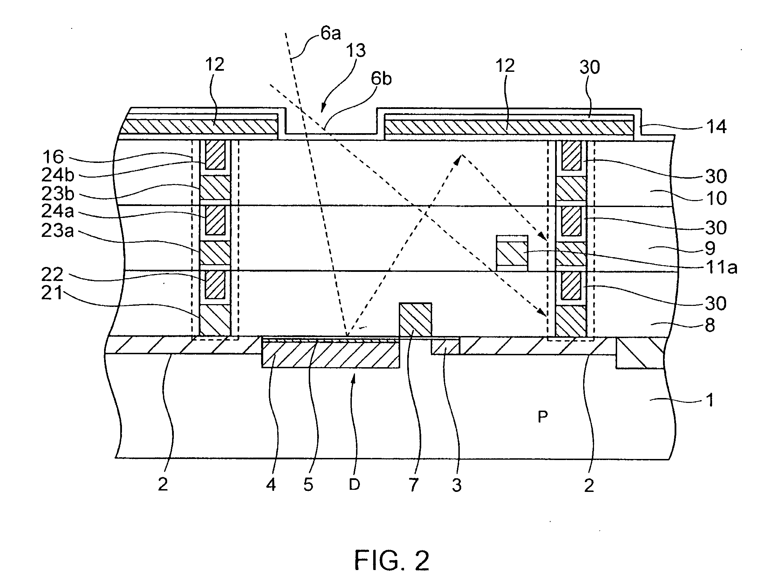

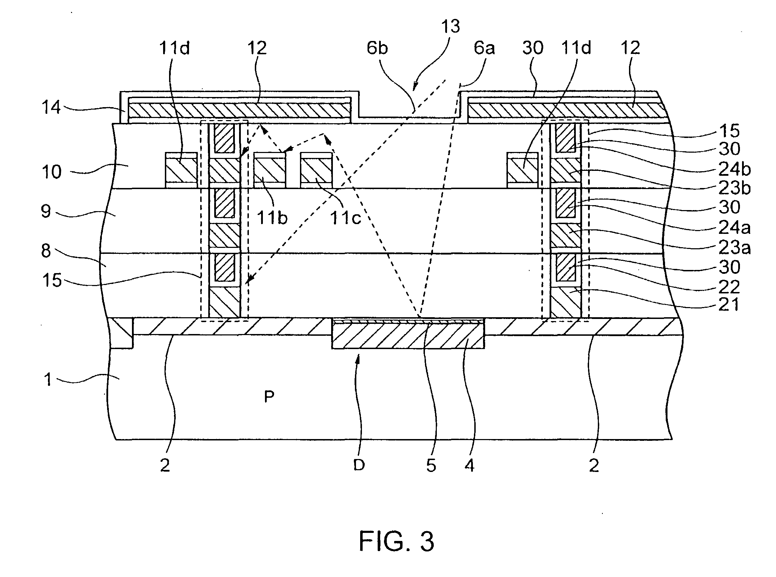

Fig. 1 is a schematic plan view showing a first embodiment of a MOS solid-state imaging device according to the present invention. Fig. 2 is a partial schematic sectional view showing one of unit cells C along the line A-a of Fig. 1. Fig. 3 is a partial schematic sectional view showing the unit cell C along the line B-b of Fig. 1. In these drawings, like reference numerals denote similar components to their respective counterparts in the prior art.

A circuit configuration of this exemplary MOS solid-state imaging device is totally the same as that of the prior art MOS solid-state imaging device and as depicted in Fig. 15 and hence, descriptions thereof are omitted.

Referring to Figs. 1 to 3, structural characteristics of the MOS solid-state imaging device will be detailed below.

As shown in Fig. 1, a semiconductor substrate 1 is overlaid with a plurality of unit cells C in matrix where rows and columns of them are lined in two-dimensional array, and each of the unit cells C is surrounded by a cell formation area defined by a device isolation region.

Metal wiring layers 11b, 11c and 11d are deposited transversely in the drawing through the cell formation areas in the vicinities of the rows of the unit cells C, and the layers 11b and 11c serving as a reset signal line Sr and a readout signal line Sm are on one side of each unit cell while the layer 11d serving as an address signal line Sh is on the opposite side of the unit cell.

A first light shield upright barrier wall 15, which extends transversely in the drawing between the adjacent unit cells C in the same column, functions as a partition between adjacent photodiodes D in the same column so as to prevent incident light upon one photodiode from trespassing any adjacent one.

The first light shield upright barrier wall 15 is shaped like a rectangular parallelepiped of which transverse sides are considerably longer in cross section, and this upright barrier wall between the adjacent unit cells is useful to somewhat block the incident light although it should be longer than a transverse extension of a unit of the photodiode D and the transistors in order to attain a complete confinement of light.

On the other hand, a metal wiring layer 11a is deposited longitudinally in the drawing through the cell formation areas in the vicinity of the columns of the unit cells C so as to serve as a signal line Sv, and a second light shield upright barrier wall 16, which extends longitudinally in the drawing between the adjacent unit cells C in the same row, functions as a partition between the adjacent photodiodes D in the same row so as to prevent incident light upon one photodiode from trespassing any adjacent one.

The second light shield upright barrier wall 16 is shaped like a rectangular parallelepiped of which longitudinal sides are considerably longer in cross section, and this upright barrier wall between the adjacent unit cells is useful to somewhat block the incident light although it should be longer than a longitudinal extension of the photodiode D in order to completely confine light.

Also, to prevent the incident light from propagating diagonally upon the photodiode D, it is preferable that ends of the light shield upright barrier walls 15 and 16 meet together, or otherwise, one end extends beyond a prolonged imaginary line from the other.

As to the single unit cell C, as will be recognized in Figs. 2 and 3, for example, the cell formation area defined by the device isolation region 2 in the surface of the P type semiconductor substrate 1 is provided with an N type drain layer 3 and an N type charge accumulating layer 4, and the latter is to serve as the photodiode D. The N type charge accumulating layer 4 is overlaid with a P⁺ surface shield layer 5. In this manner, P⁺NP embedded photodiode D is created to accumulate a certain level of signal charge, depending upon an amount of incident light 6a. Also, a gate 7 is formed on an overlying gate oxide film, in position between the N type charge accumulating layer 4 and the N type drain layer 3, and thus, a readout transistor T1 is configured in this manner.

In the vicinity of the readout transistor T1, there are formed over the surface of the P type semiconductor substrate 1 an N type source layer, an N type drain-source shared layer, and an N type drain layer, gates are formed on the overlying gate oxide film, in positions between the N type source layer and the N type drain-source shared layer and between the N type drain-source shared layer and the N type drain layer, respectively. In this manner, an amplification transistor T2 and a selector transistor T3 are configured. In addition to that, adjacent to the readout transistor T1 in the surface part of the P type semiconductor substrate 1, an N type source layer and an N type drain layer are formed, and a gate is formed on the overlying gate oxide film, in position between the N type source layer and the N type drain layer, thereby configuring a reset transistor T4 in such a manner.

Then, as shown in Figs. 2 and 3, first, second, and third interlayer films 8, 9 and 10 are successively formed in this order over the surface of the P type semiconductor substrate 1, and thereafter, the metal wiring layer 11a is deposited over the first interlayer film 8 to serve as the signal line Sv while the metal wiring layers 11b, 11c and 11d are selectively deposited over the second interlayer film 9 to serve as the reset signal line Sr, the readout signal line Sm, and the address signal line Sh, respectively.

Over the third interlayer film 10 , a light shield film 12 is formed, extending transversely in the drawings. The light shield film 12 has an aperture 13 defined to direct incident light at the photodiode D. The third interlayer film 10 along with the light shield film 12 is overlaid with a surface protection layer 14 of silicon nitride film or the like.

The first and second light shield upright barrier walls 15 and 16 vertically extend from the surface of the device isolation region 2 on the P type semiconductor substrate 1 through the first, second and third interlayer films 8, 9 and 10 up to the bottom surface of the light shield film 12.

The first and second light shield upright barrier walls 15 and 16 are of laminations that respectively consist of a dummy gate 21 and a dummy contact 22 defined in the first interlayer film 8, a dummy metal wiring layer 23a and a dummy plug 24a defined in the second interlayer film 9, and a dummy metal wiring layer 23b and a dummy plug 24b defined in the third interlayer film 10. The dummy contact 22 and the dummy plugs 24a and 24b have their respective lateral sides coated with anti-reflection film 30 that also serves as barrier metal.

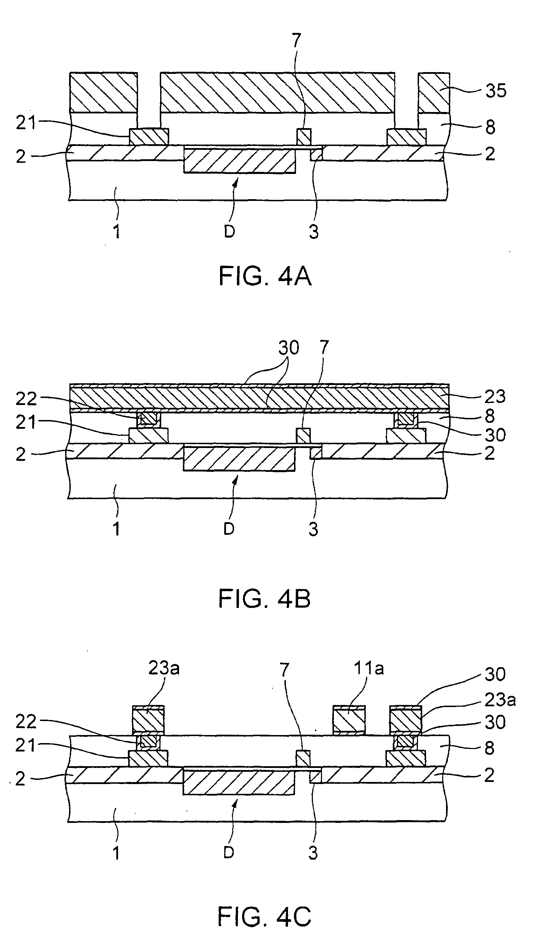

A manufacturing method of the aforementioned MOS solid-state imaging device will now be described, with reference to Figs. 4A and 4I. Figs. 4A and 4I are partial sectional diagrams illustrating a sequence of steps of manufacturing the unit cells in the MOS solid-state imaging device.

First, as shown in Fig. 4A, after a gate oxide film is formed over the P type semiconductor substrate 1, a film of gate electrode material is deposited and then patterned by an ordinary photo-etching technique to leave the gates of the transistors T1 to T4 on the gate oxide film, and simultaneous with this, the dummy gate 21 is created on a dummy gate oxide film 2.

Next, the first interlayer film 8 is formed over the P type semiconductor substrate 1, and thereafter, the ordinary photo-etching technique is used to define a contact hole in the first interlayer film 8 and a dummy contact hole in the dummy gate 21 as well, simultaneously. Then, resist 35 used during the photo-etching procedure is peeled off.

As can be seen in Fig. 4B, the first interlayer film 8 having the contact hole and the dummy contact hole defined therein is then overlaid with the anti-reflection film 30 such as Ti/TiN lamination film, which is also to serve as barrier metal. After that, contact material such as tungsten is deposited over the anti-reflection film 30. The contact material and the anti-reflection film 30 are then removed by a well-known flattening technique till the first interlayer film 8 is exposed, and thereafter, the contact hole is filled with the contact material to create an embedded contact while the dummy contact hole is simultaneously filled with the same material to create the embedded dummy contact 22. Subsequent to that, the anti-reflection film 30 is deposited over the first interlayer film 8, covering the upper surfaces of the contact and dummy contact as well, and a film 23 of metal such as aluminum, copper, or the like is deposited over the anti-reflection film to provide wirings. The anti-reflection film 30 is further deposited over the metal film 23 again.

After that, as shown in Fig. 4C, the metal film 23 and the anti-reflection film 30 are patterned by the well-known photo-etching and reactive ion etching (RIE) techniques to have the metal wiring layer 11a and the dummy metal wiring layer 23a left over the dummy contact 22.

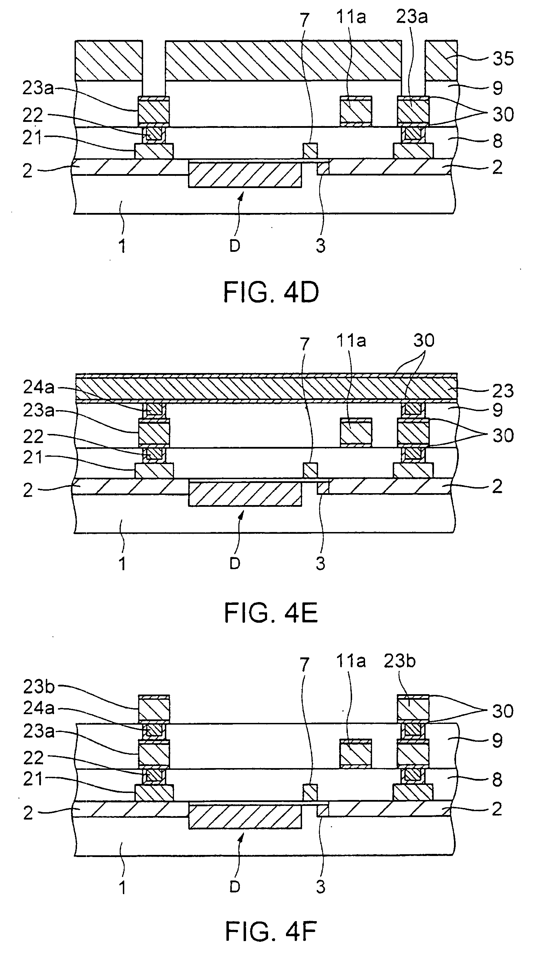

Subsequently, as can be seen in Fig. 4D, the second interlayer film 9 is formed over the first interlayer film 8, covering the metal wiring layer 11a and the dummy metal wiring layer 23a as well, and thereafter, the well-known photo-etching technique is used to define a via hole (not shown) in the second interlayer film 9 in position registered with the metal wiring layer 11a and simultaneously a dummy via hole, as well, in position registered with the dummy metal wiring layer 23a. Then, the resist 35 used during the photo-etching procedure is peeled off.

Further, as shown in Fig. 4E, subsequent to the deposition of the anti-reflection film 30 over the second interlayer film 9 as well as the via hole and the dummy via hole, plug material such as tungsten is deposited to connect wirings over the anti-reflection film 30. The plug material and the anti-reflection film 30 are eliminated by the well-known flattening technique till the second interlayer film 9 is exposed, and succeedingly, the via hole is filled with the plug material to define the embedded plug while the dummy via hole is simultaneously filled with the same material to create the embedded dummy plug 24a.

Then, the second interlayer film 9 is coated with anti-reflection film 30, covering the upper surfaces of the plug and the dummy plug 24a, and after the metal film 23 is deposited over the anti-reflection film 30 for wirings, the metal film 23 is further coated with the anti-reflection film 30.

Furthermore, as depicted in Fig. 4F, the metal film 23 and the anti-reflection film 30 are patterned by the well-known photo-etching and RIE techniques to leave the metal wiring layers 11b, 11c, and 11d (not shown) and simultaneously the dummy metal wiring layer 23b as well.

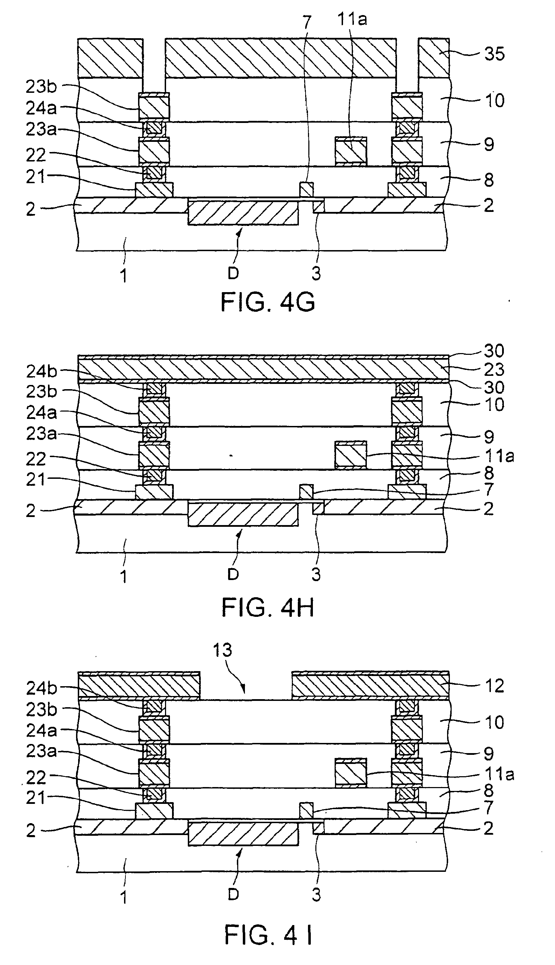

Next, as shown in Fig. 4G, after the second interlayer film 9 along with the metal wiring layers 11b, 11c and 11d (not shown) and the dummy metal wiring layer 23b are coated with the third interlayer film 10, the ordinary PEP technique is used to define via holes in the third inter layer film 10 in positions registered with the metal wiring layers 11b, 11c and 11d (not shown), respectively, and simultaneously a dummy via hole, as well, in position registered with the dummy metal wiring layer 23b. After that, the resist 35 used during the photo-etching procedure is peeled off.

Subsequent to that, as shown in Fig. 4H, after the anti-reflection film 30 is deposited over the third interlayer film 10, covering the via holes and the dummy via hole as well, the plug material such as tungsten is further deposited to connect the wirings over the anti-reflection film 30. The plug material and the anti-reflection film 30 are eliminated by the ordinary flattening technique till the third interlayer film 10 is exposed, and thereafter, the via holes are filled with the plug material to define the embedded plugs while the dummy via hole is simultaneously filled with the same material to create the embedded dummy plug 24b as well. Then, the anti-reflection film 30 along with the upper surfaces of the plugs and the dummy plugs 24b are coated with the anti-reflection film 30, and after the metal film 23 is further deposited over the anti-reflection film 30 to serve as the light shield film, the metal film 23 is further overlaid with the anti-reflection film 30.

Then, as shown in Fig. 4I, the well-known PEP and RIE techniques are used to pattern the metal film 23 and the anti-reflection film 30 so as to define the light shield film 12 and the aperture 13.

Finally, as depicted in Fig. 2, a surface protection layer 14 is formed to complete the MOS solid-state imaging device.

In the aforementioned first embodiment, the first and second light shield upright barrier walls 15 and 16 are located between the adjacent ones of the unit cells C in the same column and row, respectively, so as to function as partitions in the vicinities of them. Thus, even when the incident light 6a upon the photodiode D through the aperture 13 is partially reflected from the surface of the semiconductor substrate 1, and the reflected light is further irregularly reflected from the light shield film 12 and the metal wiring layers 11a, 11b, 11c and 11d, respectively, to cause stray light, the barrier walls are useful to confine the light in the unit cell C and prevent it from trespassing other photodiodes D in the adjacent unit cells. In addition to that, the incident light 6b diagonally directed through the aperture 13 is also effectively blocked so as not to trespass the adjacent photodiodes. Hence, the resultant MOS solid-state imaging device can attain features of reduced cross-talk and enhanced chromatic reproducibility.

In accordance with the aforementioned manufacturing method, a combination of the well-known procedures enables to form the gate oxide film, the gates, the contacts, the metal wiring layers, and the plugs simultaneous with the formation of the dummy gate oxide film, the dummy gate 21, the dummy contact 22, the dummy metal wiring layers 23a and 23b, and the dummy plugs 24a and 24b to build up the first and second light shield upright barrier walls 15 and 16, and hence, a fabrication of the aforementioned improved MOS solid-state imaging device is facilitated without additional manufacturing steps.

### <Modified Embodiment 1>

In the first embodiment of the present invention, the metal wiring layers 11a, the dummy metal wiring layers 23a and 23b, and the light shield film 12 have their respective lateral sides not covered or coated with the anti-reflection film 30. This probably causes a degradation of the chromatic reproducibility because the stray light resulted from irregular reflection at these parts trespasses the associated photodiode D.

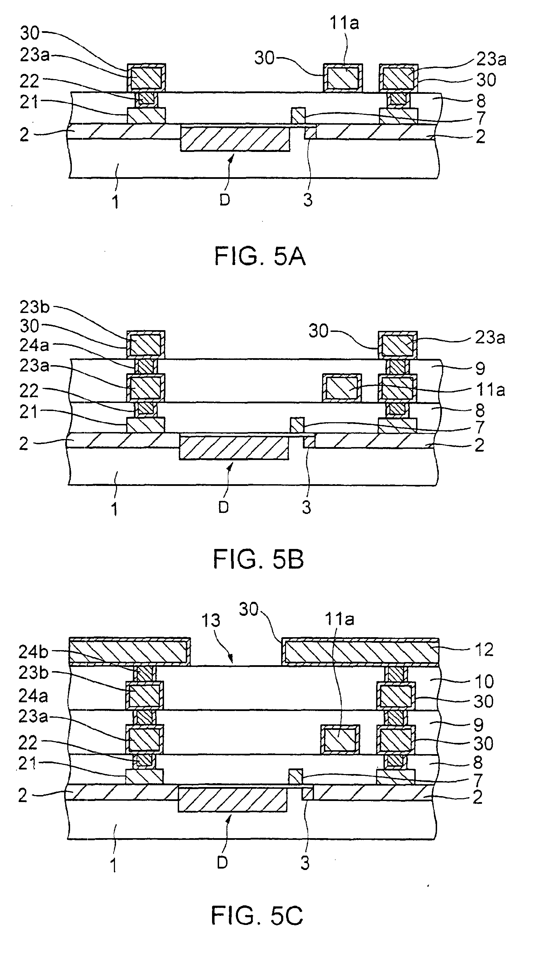

Thus, it is desirable that the parts are covered with the anti-reflection film 30. For that purpose, the number of manufacturing steps is increased; for example, as in Fig. 5A, the steps illustrated in Fig. 4C are succeeded by an additional procedure where the anti-reflection film 30 is deposited over the first interlayer film 8 while covering the metal wiring layer 11a and the dummy metal wiring layer 23a as well, and the well-known anisotropic etching method such as RIE is used to eliminate the anti-reflection film 30 from the first interlayer film 8 but not from the upper and lateral sides of the metal wiring layer 11a and the dummy metal wiring layer 23a.

Similarly, the steps illustrated in Fig. 4F are succeeded by a further additional procedure as depicted in Fig. 5B where the anti-reflection film 30 is deposited over the metal wirings 11b, 11c and 11d (not shown) and the second interlayer film 9 while covering the dummy metal wiring layer 23b as well, and the well-known anisotropic etching method such as RIE is used to eliminate the anti-reflection film 30 from the second interlayer film 9 but not from the upper and lateral sides of the metal wiring layers 11b, 11c and 11d and the dummy metal wiring layer 23b.

Also, similarly, the steps in Fig. 4I are succeeded by another procedure as in Fig. 5C where after the anti-reflection film 30 is deposited over the third interlayer film 10 while covering the light shield film 12 as well, the well-known anisotropic etching method such as RIE is used to eliminate the anti-reflection film 30 from the third interlayer film 10 but not from the upper and lateral sides of the light shield film 12.

### <Modified Embodiment 2>

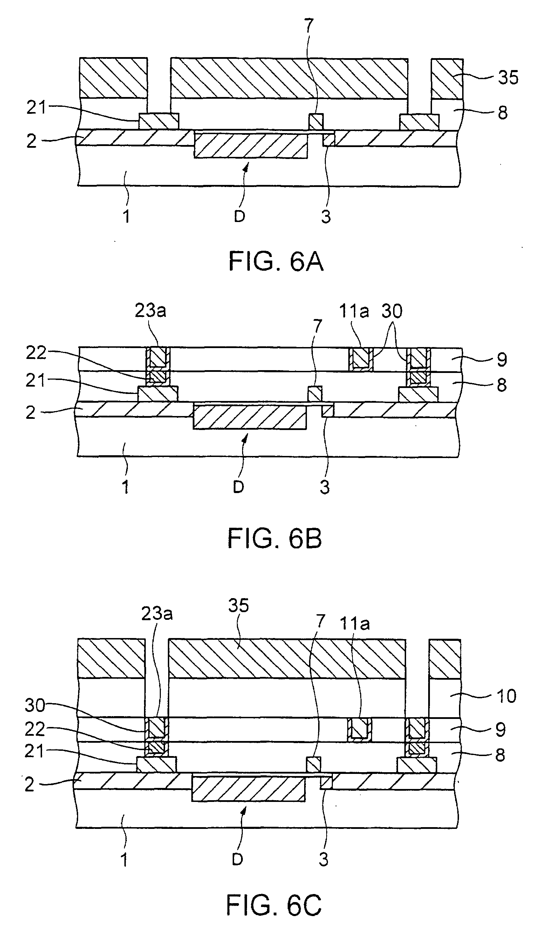

Another manufacturing method of the MOS solid-state imaging device will be described with reference to Figs. 6A to 6H. Figs. 6A to 6H are partial sectional diagrams showing steps of manufacturing the unit cells in the MOS solid-state imaging device.

First, as depicted in Fig. 6A, after a P type semiconductor substrate 1 is overlaid with a gate oxide film, a film of gate electrode material is deposited and patterned by an ordinary photo-etching technique to leave gates of transistors T1 to T4 on the gate oxide film and simultaneously form a dummy gate 21.

Then, after the P type semiconductor substrate 1 is further coated with a first interlayer film 8, the well-known photo-etching technique is used to define a contact hole in the first interlayer film 8 and simultaneously a dummy contact hole, as well, in position registered with the dummy gate 21. Subsequently, resist 35 used during the photo-etching procedure is peeled off.

Then, as can be seen in Fig. 6B, the first interlayer film 8 along with the contact hole and the dummy contact hole defined therein is then overlaid with an anti-reflection film 30 such as Ti/TiN lamination film, which is also to serve as barrier metal. After that, the anti-reflection film 30 is coated with contact material such as tungsten. The contact material and the anti-reflection film 30 are eliminated by the ordinary flattening technique till the first interlayer film 8 is exposed, and the contact hole is filled with the contact material to define an embedded contact while the dummy contact hole is simultaneously filled with the same material to create an embedded dummy contact 22.

Next, after a second interlayer film 9 is formed over the first interlayer film 8, covering the contact and the dummy contact 22 as well, the well-known photo-etching technique is used to define an aperture in the second interlayer film 9 for a metal wiring layers and simultaneously an aperture in position right above the dummy contact 22 for a dummy metal wiring layer. Subsequently, the anti-reflection film 30 is deposited over the second interlayer film while covering the apertures for the metal wiring layer and the dummy metal wiring layer, and thereafter, the anti-reflection film 30 is coated with metal wiring material. The metal wiring material is eliminated by the ordinary flattening technique till the second interlayer film 9 is exposed, and the aperture for the metal wiring layer is filled with the metal wiring material to define an embedded metal wiring layer 11a while the aperture for the dummy metal wiring layer is simultaneously filled with the same material to create an embedded dummy metal wiring layer 23a.

Succeedingly, as depicted in Fig. 6C, after a third interlayer film 10 is formed over the second interlayer film 9 while covering the metal wiring layer 11a and the dummy metal wiring layer 23a as well, the well-known photo-etching technique is used to define a via hole (not shown) in the third interlayer film 10, in position registered with the metal wiring 11a, and simultaneously a dummy via hole, as well, in position right above the dummy metal wiring 23a. After that, resist 35 used during the photo-etching procedure is peeled off.

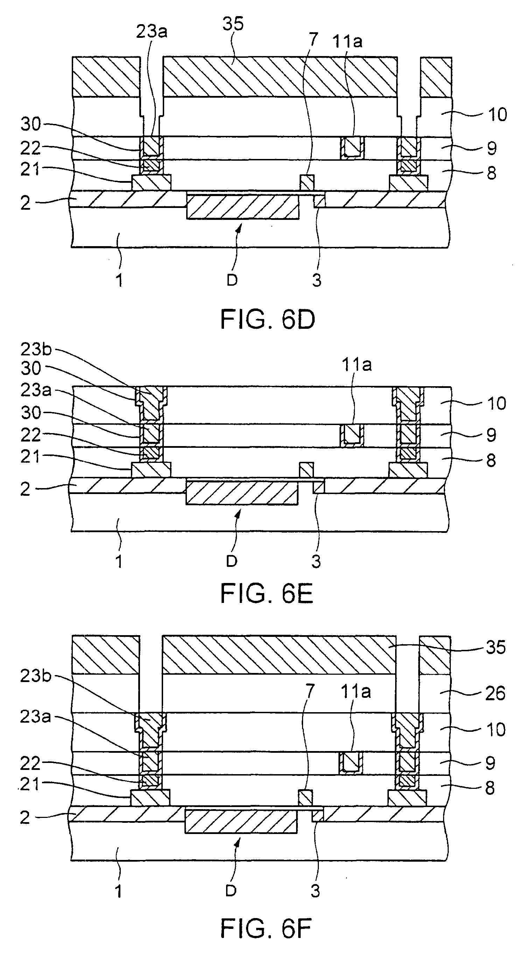

Subsequent to that, as illustrated in Fig. 6D, the ordinary photo-etching technique is used to define a groove for a metal wiring and simultaneously another groove right above the dummy via hole for a dummy metal wiring, and thereafter, the resist 35 used during the photo-etching is peeled away.

Then, as shown in Fig. 6E, the anti-reflection film 30 is deposited over the third interlayer film 10, covering the via hole, the metal wiring groove, the dummy via hole, and the dummy metal wiring groove as well, and thereafter, the anti-reflection film 30 is overlaid with metal wiring material that is also to serve as a plug in the via hole. The metal wiring material serving as the plug is eliminated by the ordinary flattening technique till the third interlayer film 10 is exposed, and the via hole and the metal wiring layer groove are filled with the metal wiring material to define metal wiring layers 11b, 11c and 11d (not shown) that are also to serve as embedded plugs while the dummy via hole and the dummy metal wiring layer groove are simultaneously filled with the same material to create a dummy metal wiring layer 23b that is also to serve as an embedded dummy plug.

Next, as shown in Fig. 6F, after a fourth interlayer film 26 is formed over the third interlayer film 10 while covering the metal wiring layers 11b, 11c and 11d (not shown) and the dummy metal wiring layer 23b, and the ordinary photo-etching technique is used to define via holes in the fourth interlayer film 26, in positions registered with the metal wiring layers 11b, 11c and 11d (not shown), respectively, and simultaneously a dummy via hole right above the dummy metal wiring 23b. Subsequently, the resist 35 used during the photo-etching technique is peeled away.

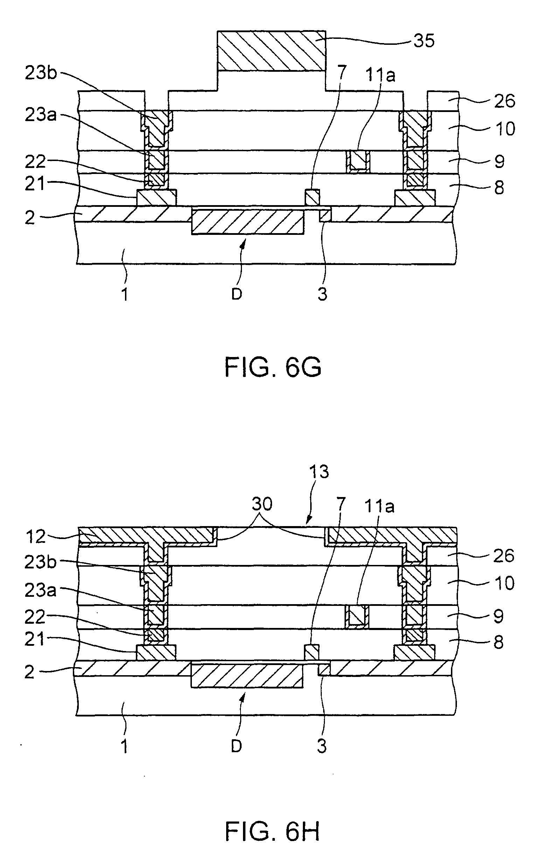

Then, as shown in Fig. 6G, the ordinary photo-etching technique is used to define a groove for a light shield film 12 in the fourth interlayer film 26, in position right above the dummy via hole, and after that, the resist 35 used during the photo-etching procedure is peeled off.

As will be recognized in Fig. 6H, the anti-reflection film 30 is deposited over the fourth interlayer film 26, covering the via hole, the dummy via hole, and material for the light shield film 12 as well, and thereafter, the anti-reflection film 30 is coated with the light shield film that is also to serve as a plug. The material for the light shield film serving as the plug is eliminated by the ordinary flattening technique till the fourth interlayer film 26 is exposed, and the via hole is filled with the light shield film material to define an embedded plug while the dummy via hole and the groove for the light shield film 12 are simultaneously filled with the same material to shape the light shield film 12 that is also to serve as an embedded dummy plug.

Eventually, a surface protection layer 14 not shown is formed to finish the improved MOS solid-state imaging device.

### <Modified Embodiment 3>

In the aforementioned manufacturing method, the upper side of the metal wiring layers 11a, the vicinity of the upper sides of the dummy metal wiring layers 23a and 23b, and the upper side of the light shield film 12 are not coated with the anti-reflection film 30. This probably causes a degradation of the chromatic reproducibility because the stray light resulted from irregular reflection at these parts trespasses the associated photodiode D.

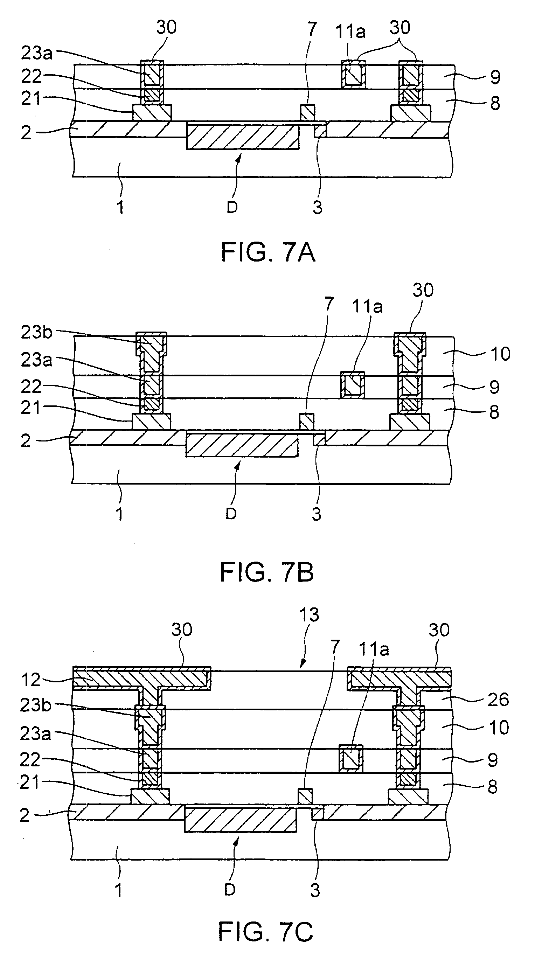

Thus, it is desirable that the parts are covered with the anti-reflection film 30. For that purpose, the number of manufacturing steps is increased; for example, as in Fig. 7A, the steps illustrated in Fig. 6B are succeeded by an additional procedure where the anti-reflection film 30 is deposited over the second interlayer film 9 while covering the metal wiring layer 11a and the dummy metal wiring layer 23a as well, and the ordinary photo-etching method and the well-known anisotropic etching method such as RIE are used to eliminate the anti-reflection film 30 from the second interlayer film 9 but not from the upper sides of the metal wiring layer 11a and the dummy metal wiring layer 23a.

Similarly, the steps illustrated in Fig. 6E are succeeded by a further additional procedure as depicted in Fig. 7B where the anti-reflection film 30 is deposited over the third interlayer film 10 while covering the dummy metal wiring layer 23b as well, and the ordinary photo-etching method and the well-known anisotropic etching method such as RIE are used to eliminate the anti-reflection film 30 from the third interlayer film 10 but not from the upper side of the dummy metal wiring layer 23b.

Also, similarly, the steps in Fig. 6H are succeeded by another procedure as in Fig. 7C where after the anti-reflection film 30 is deposited over the fourth interlayer film 26 while covering the light shield film 12 as well, the ordinary photo-etching method and the well-known anisotropic etching method such as RIE are used to eliminate the anti-reflection film 30 from the fourth interlayer film 26 but not from the upper side of the light shield film 12.

### <Embodiment 2>

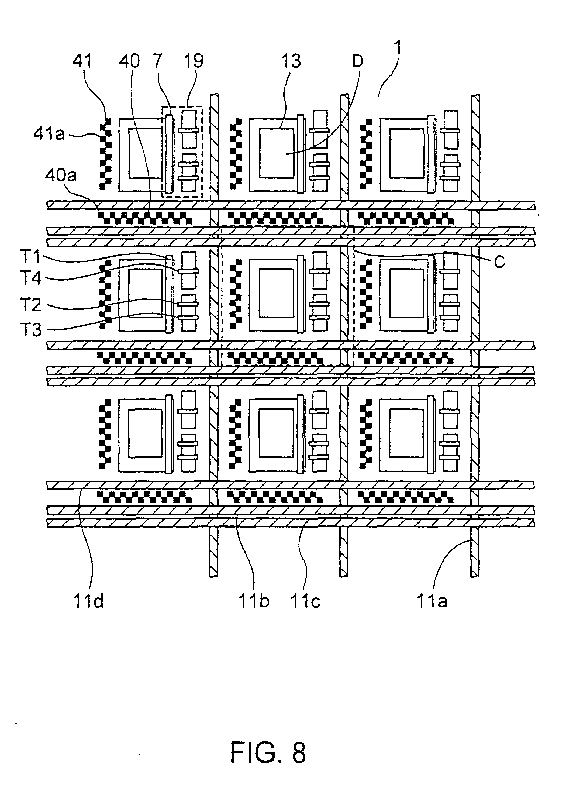

Fig. 8 is a schematic plan view showing a second embodiment of the MOS solid-state imaging device according to the present invention. Like reference numerals denote similar components to those in the first embodiment, and descriptions of them are omitted.

The second embodiment is different from the first embodiment in that, as shown in Fig. 8, first and second light shield upright barrier walls 40 and 41 are replaced with the first and second light shield upright barrier walls 15 and 16, and the barrier walls 40 respectively consist of a plurality of barrier blocks 40a and 41a that are respectively shaped in zigzag deployment. The barrier blocks 40a and 41a are respectively comprised of a dummy gate 21, a dummy contact 22, dummy metal wiring layers 23a and 23b, and dummy plugs 24a and 24b, similar to the first embodiment.

Such a MOS solid-state imaging device can be obtained by basically the same manufacturing method as that of the first embodiment. For instance, in order to finish the MOS solid-state imaging device, a device isolation region or a dummy gate oxide film is overlaid with the dummy gate 21, the dummy contact 22, the dummy metal wiring layer 23a, the dummy plug 24a, the dummy metal wiring layer 23b, and the dummy plug 24b that build up a zigzag lamination together.

In this embodiment, similar to the first embodiment, the first and second light shield upright barrier walls 40 and 41 are located in the vicinities of rows and columns of unit cells C, respectively, to function as partitions between the adjacent unit cells C in the same column and row, and hence, even when incident light 6a upon a photodiode D through an aperture 13 in the unit cell C is partially reflected from the surface of a semiconductor substrate 1, and the reflected light is further irregularly reflected from a light shield film 12 and metal wiring layers 11a, 11b, 11c and 11d, respectively, to cause stray light, the barrier walls are useful to confine the light in the unit cell C and prevent it from trespassing other photodiodes D in the adjacent unit cells.

In addition to that, incident light 6b diagonally directed is also effectively blocked so as not to trespass the adjacent photodiodes. Hence, the resultant MOS solid-state imaging device can attain features of reduced cross-talk and enhanced chromatic reproducibility like color mixing.

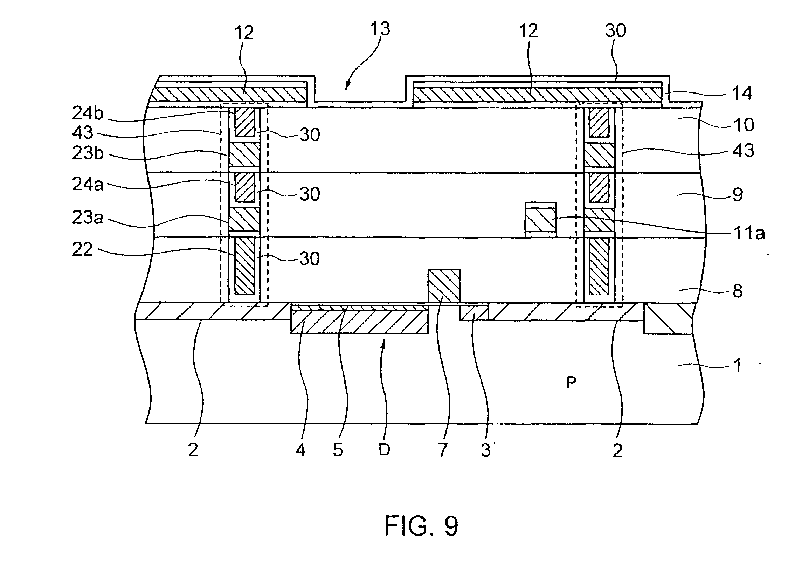

The present invention should not be limited to any particular embodiment as mentioned above, and instead, it should be noted that various modifications can be made without departing from the true scope of the invention. For example, in the aforementioned first and second embodiments, the first light shield upright barrier walls 15 and 40, and the second light shield upright barrier walls 16 and 41 may alternatively be configured as illustrated in Fig. 9 where the dummy gate 21 is removed, and instead, the dummy contact 22 extends down to the device isolation region.

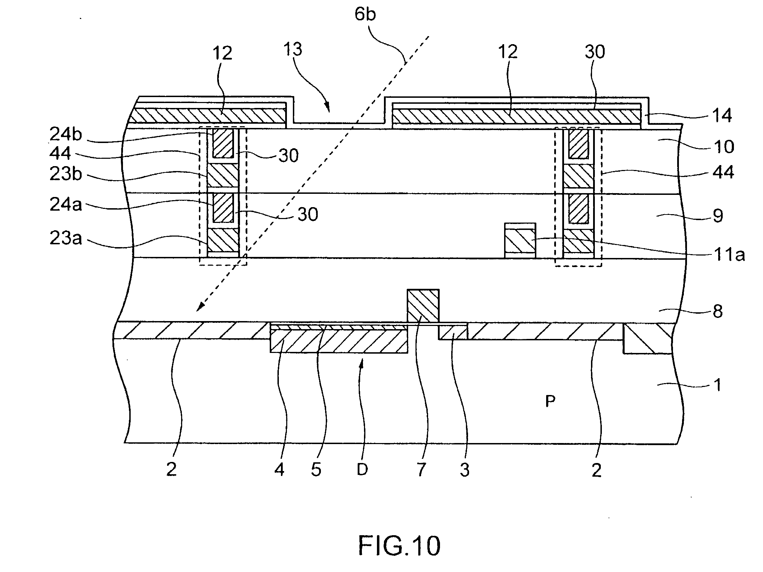

Also, as can be seen in Fig. 10, those barrier walls may be configured without the dummy gate 21 but with only dummy metal wiring layers 23a and 23b, and dummy plugs 24a and 24b. In such a case, however, it is important that the photodiode D in the unit cell C keeps off imaginary line extended from the aperture 13 to meet lower ends of the barrier walls 15, 16, 40 and 41 so as to prevent diagonal incident line 6a from trespassing the photodiodes D in the adjacent unit cells C.

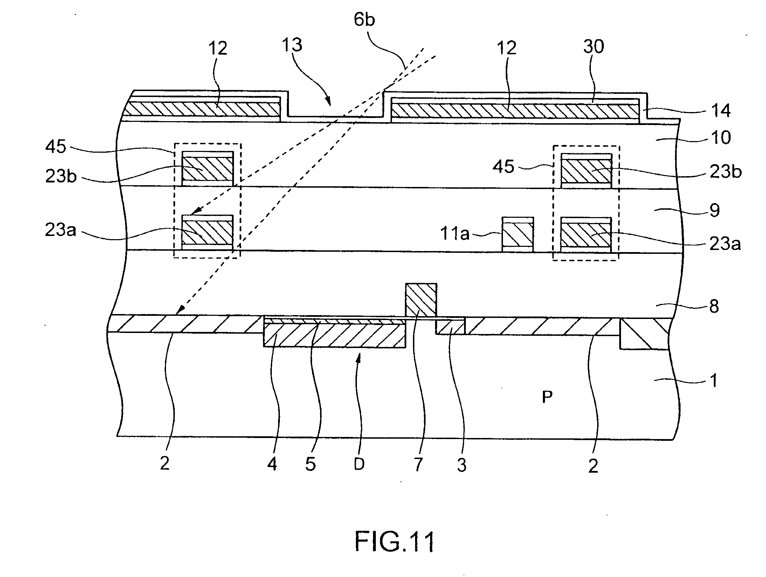

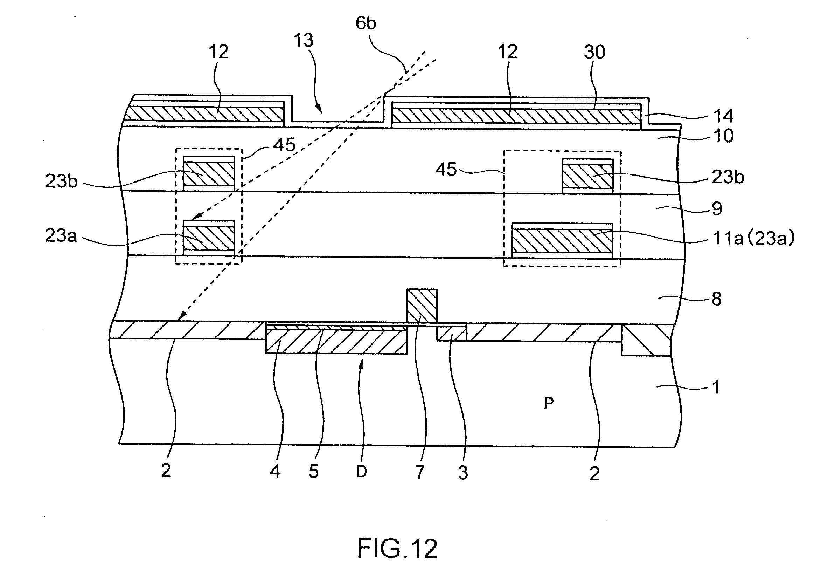

Alternatively, as depicted in Fig. 11, the barrier walls may be built up simply with the dummy metal wiring layers 23a and 23b. In this case, widths of the dummy metal wiring layers 23a and 23b must be widened in order that none of the photodiodes D in the adjacent unit cells C exist on an imaginary line extended from the aperture 13 to meet the upper end of the dummy metal wiring layer 23a and the lower end of the dummy metal wiring layer 23b. Furthermore, in such a case, as shown in Fig. 12, it is possible to commonly provide the metal wiring layer 11a and the dummy metal wiring layer 23a, unless any functional problem may occur.

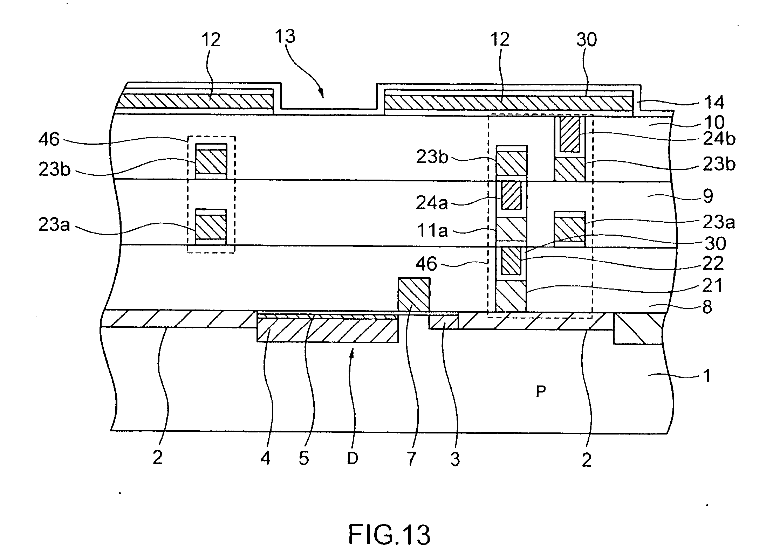

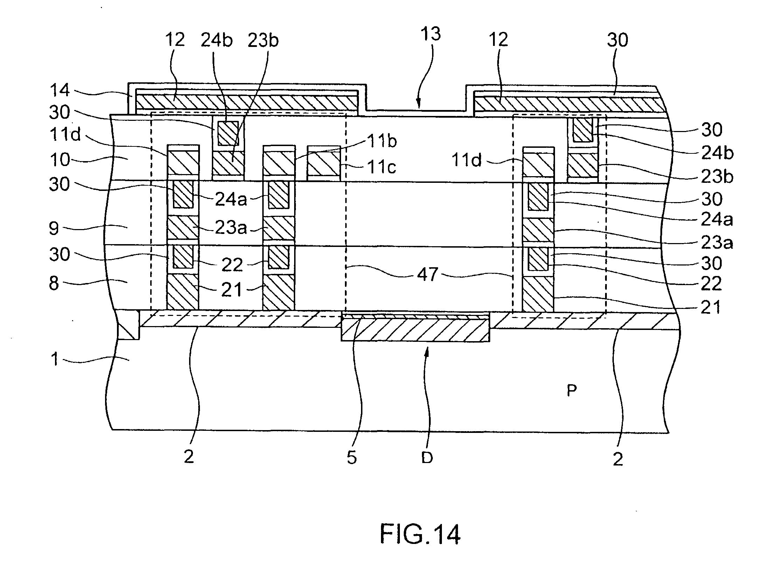

Further alternatively, as shown in Figs. 13 and 14, the barrier walls may be of the metal wiring layers 11a, 11b, 11c and 11d, the dummy gate 21, the dummy contact 22, the dummy metal wiring layers 23a and 23b, and the dummy plug 24a in combination.

As has been described, in accordance with the embodiment of the present invention, since the first and second light shield upright barrier walls are located in the vicinities of rows and columns of the unit cells, respectively, to intervene between the adjacent unit cells in the same column and row, they effectively confine diagonal incident light through an aperture in the light shield film and/or stray light due to irregular reflection and prevent such light from trespassing any of the adjacent photodiodes, and thus, cross-talk can be reduced while color mixing is improved, which brings about an attainment of the MOS solid-state imaging device having a feature of enhanced chromatic reproducibility.

## Claims

1. A solid-state imaging device comprising
unit cells in matrix where rows and columns of them are arranged in an upper surface of a semiconductor substrate, each of the unit cells including a photodiode that develops a certain level of signal charge in response to an amount of incident light and accumulates the signal charge, and a readout circuit for reading the signal charge from the photodiode,
interlayer films laid over the semiconductor substrate and having wiring layers provided therein,
light shield film formed over the interlayer films and having an aperture provided right above the photodiode in each of the unit cells,
trains of first light shield upright barrier walls located in a space between two adjacent unit cells arranged in the same column, and
trains of second light shield upright barrier walls located in a space between the adjacent unit cells in the same row,
the first and second light shield upright barrier walls being embedded in the interlayer films between the semiconductor substrate and the light shield film.

2. The solid-state imaging device according to claim 1, wherein said first and second light shield upright barrier walls are shaped like rectangular parallelepipeds of which have longer extending length than their sides in cross section.

3. The solid-state imaging device according to claim 2, wherein said first and second light shield upright barrier walls have sufficient extending lengths to prevent incident light from the aperture of the light shield film from reaching the photodiodes of adjacent unit cells arranged in the column and/or row directions.

4. The solid-state imaging device according to claim 3, wherein said first and second light shield upright barrier walls have extending lengths substantially equal to or more than the lengths of the sides the photodiodes, the sides opposing to the first or second light shield upright barrier walls.

5. The solid-state imaging device according to claim 2, wherein the first and second light shield upright barrier walls respectively extend in vertical direction from the upper surface of the semiconductor substrate up to the light shield film. 5.

6. The solid-state imaging device according to claim 1, wherein the first and second light shield upright barrier walls respectively have a plurality of light shield upright barrier blocks arranged in zigzag deployment.

7. The solid-state imaging device according to claim 6, wherein said first and second light shield upright barrier walls have extending lengths substantially equal to or more than the lengths of the sides the photodiodes, the sides opposing to the first or second light shield upright barrier walls.

8. The solid-state imaging device according to claim 6, wherein the first and second light shield upright barrier walls respectively extend in vertical direction from the upper surface of the semiconductor substrate up to the light shield film.

9. The solid-state imaging device according to claim 1, wherein the first and second light shield upright barrier walls are respectively built up by stacking any of a dummy gate oxide film, a dummy gate, a dummy contact, a dummy wiring layer, and a dummy plug in combination.

10. The solid-state imaging device according to claim 1, wherein the first and second light shield upright barrier walls are of metal.

11. The solid-state imaging device according to claim 1, wherein the first and second light shield upright barrier walls are respectively build up by stacking any of a dummy gate oxide film, a dummy gate, a dummy contact, a dummy wiring layer, and a dummy plug in combination with a metal wiring layer.

12. The solid-state imaging device according to claim 11, wherein said dummy wiring layer and said metal wiring layer are commonly provided.

13. A solid-state imaging device according to claim 1, wherein the first and second light shield upright barrier walls have their respective side surfaces covered with anti-reflection film.
